Europäisches Patentamt

European Patent Office

Office européen des brevets

(11) Numéro de publication : **0 407 269 B1**

# (12) FASCICULE DE BREVET EUROPEEN

(45) Date de publication du fascicule du brevet :
**17.06.92 Bulletin 92/25**

(51) Int. Cl.$^5$ : **H03K 3/023, G06F 1/08**

(21) Numéro de dépôt : **90401856.1**

(22) Date de dépôt : **28.06.90**

(54) **Circuit intégré avec oscillateur réglable à fréquence indépendante de la tension d'alimentation.**

(30) Priorité : **07.07.89 FR 8909197**

(43) Date de publication de la demande :
**09.01.91 Bulletin 91/02**

(45) Mention de la délivrance du brevet :
**17.06.92 Bulletin 92/25**

(84) Etats contractants désignés :
**AT DE ES GB IT NL**

(56) Documents cités :
**EP-A- 0 165 748**
**EP-A- 0 296 668**
**US-A- 4 691 124**
**US-A- 4 767 979**

(56) Documents cités :
**A.B. WILLIAMS, "Designer's handbook of integrated circuits", 1ère édition, partie 2-2: "Waveform generators", 1984,McGraw-Hill, New York, US, pp 2-19 à 2-21.**

(73) Titulaire : **SGS-THOMSON MICROELECTRONICS S.A.**
**7, Avenue Galliéni**
**F-94250 Gentilly (FR)**

(72) Inventeur : **Nicolai, Jean**
**Cabinet BALLOT-SCHMIT, 7, rue le Sueur**
**F-75116 Paris (FR)**

(74) Mandataire : **Schmit, Christian Norbert Marie et al**
**Cabinet Ballot-Schmit 7, rue Le Sueur**
**F-75116 Paris (FR)**

EP 0 407 269 B1

Jouve, 18, rue Saint-Denis, 75001 PARIS

## Description

L'invention concerne la fabrication des circuits intégrés.

Dans beaucoup de circuits intégrés, il est nécessaire de disposer d'une horloge. C'est le cas par exemple pour un processeur de traitement de signaux qui nécessite de toutes façons une horloge assurant le séquencement régulier des opérations de traitement effectuées.

L'horloge peut être réalisée à partir d'un oscillateur interne au circuit intégré, ou bien les signaux d'horloge peuvent être appliqués à partir de l'extérieur du circuit intégré, sur une borne spécialement réservée à cet effet.

Si on utilise une horloge externe, cela impose à l'utilisateur du circuit-intégré de prévoir cette horloge, ce qui augmente indirectement le coût du circuit pour l'utilisateur. De plus, cela impose une borne de circuit réservée à l'horloge.

Lorsqu'on réalise sur un circuit-intégré un oscillateur, la difficulté est d'obtenir précisément une fréquence qu'on souhaite. En effet, les dispersions de fabrication résultant des procédés technologiques employés sont telles qu'on ne sait pas obtenir une fréquence avec une précision suffisante. La dispersion de fréquence libre d'oscillation obtenue pour deux oscillateurs identiques ayant suivi la même filière de fabrication est facilement de 100% ou même plus. Cela résulte de ce que les procédés de fabrication impliquent des étapes de dopage, de diffusion d'impuretés à haute température, de dépôts de couches isolantes minces, etc.; la reproductibilité de ces étapes d'un circuit au suivant n'est pas très facile à maîtriser.

De plus, lorsque l'on réalise un oscillateur interne sur le circuit intégré, on s'aperçoit que sa fréquence varie non seulement en fonction de la dispersion de fabrication mais aussi en fonction de la tension d'alimentation du circuit. Cela résulte de ce que la fréquence de l'oscillateur dépend des courants qui le traversent, ces courants dépendant eux-mêmes de la tension d'alimentation générale du circuit.

Ou bien la fréquence d'oscillation n'est pas critique, et alors on peut se permettre d'avoir un oscillateur entièrement intégré dans le circuit, sans borne extérieure de réception d'un signal d'horloge. Ou bien au contraire la fréquence est un paramètre critique et la solution universellement utilisée est de connecter à l'extérieur du circuit intégré des éléments de réglage de l'oscillateur interne (résistances et/ou capacités en général). Ces éléments de réglage ont une valeur connue très précisément car ils ne sont pas soumis aux mêmes dispersions de fabrication ou bien ils ont été triés. Mais l'inconvénient est qu'ils doivent être connectés directement à l'oscillateur du circuit intégré, et par conséquent ils imposent que le circuit intégré comporte des broches extérieures supplémentaires spécialement réservées à cet usage. Les broches extérieures supplémentaires devraient cependant être évitées au maximum car elles sont l'un des facteurs de coût les plus importants pour les circuits intégrés.

Dans un processeur de signaux, c'est-à-dire un circuit électronique capable d'exécuter des tâches variées de traitement de signaux sous le contrôle d'instructions, l'horloge qui détermine le séquencement des opérations exécutées par le microprocesseur est un élément de circuit très important et sa fréquence doit être bien déterminée. Dans les circuits de traitement de signaux fabriqués actuellement, l'horloge est externe ou bien elle est interne et ajustée par des composants précis extérieurs (quartz, résistances, capacités).

Le document EP-A-165748 décrit un circuit oscillateur qui permet d'obtenir plusieurs fréquences de sortie par sélection, par une impulsion de commande, de sources de courant constant ; les courants de ces sources s'ajoutent à celui d'une autre source de courant constant montée en miroir de courant avec la source de courant de charge de la capacité (moyen de charge). Le circuit décrit permet en particulier d'obtenir une haute ou une basse fréquence, mais cette fréquence n'est pas indépendante des variations de tension d'alimentation.

Le document "designer's handbook of integrated circuits" par A.B. WILLIAMS, 1ère édition, 1984, Mc Graw-Hill, pages 2-19 à 2-21 décrit un oscillateur pour lequel la fréquence d'oscillation est indépendante des variations de tension d'alimentation.

Un but de l'invention est de proposer un circuit intégré comportant une horloge interne, qui ne soit pas soumis aux inconvénients qu'on vient de décrire, et notamment à une variation de fréquence en fonction de la tension d'alimentation.

Un autre but de l'invention est de proposer un circuit qui ne soit pas soumis aux inconvénients résultant de la dispersion technologique existant entre circuits théoriquement identiques.

Un autre but de l'invention est de permettre la réalisation d'un circuit intégré comportant une horloge dont la fréquence puisse être définie facilement et précisément, sans imposer la présence de broches spécifiques de connexion pour connecter des éléments de réglage extérieurs à un oscillateur interne.

Enfin, un but de l'invention est tout spécialement la réalisation d'un processeur de traitement de signaux ayant une horloge pour assurer le séquencement de ses propres opérations, cette horloge ayant une fréquence pouvant être définie facilement par le processeur lui-même, et ne variant pas avec la tension d'alimentation.

Pour atteindre ces divers buts, la présente invention propose un circuit-intégré comprenant un oscillateur à relaxation comportant une capacité et un moyen de charge et décharge de la capacité avec des sources de courants élémentaires qui sont mises en parallèle sélectivement, un comparateur à seuils pour déclencher la charge de la capacité lorsque la tension aux bornes de celle-ci descend au dessous d'un seuil bas Vb, et pour déclencher la décharge de la capacité lorsque la tension aux bornes de celle-ci monte au dessus d'un seuil haut Vh, ce comparateur établissant des seuils haut et bas Vh et Vb tels que Vh-Vb soit proportionnel au courant de charge et décharge de la capacité cet oscillateur comportant en outre un registre contenant des données de réglage de fréquence de l'oscillateur, ce registre commandant la mise en parallèle sélective de sources de courant élémentaires en fonction de son contenu, les courants de charge et décharge de la capacité étant liés aux courants des sources élémentaires ainsi mises en parallèle.

Avec cette proportionalité, on arrive à rendre la fréquence d'oscillation indépendante de la tension d'alimentation (la tension d'alimentation faisant varier fortement la valeur des sources de courant élémentaires mais n'affectant pas pour autant, comme on le verra, la fréquence de l'oscillateur).

Le registre peut être chargé avec une valeur numérique représentant une fréquence de l'oscillateur ou une correction d'une fréquence de base de l'oscillateur. Cette valeur numérique peut prendre en compte, comme on le verra, des données de correction résultant de l'incertitude de la fréquence de base de l'oscillateur par suite de la dispersion technologique à la fabrication.

Les sources de courant élémentaires ont de préférence des valeurs pondérées, par exemple selon un code binaire pur, les bits du registre ayant une pondération correspondante.

Dans le cas où le circuit intégré comporte un processeur de traitement de signaux, on prévoit de préférence que celui-ci est apte à charger une valeur désirée dans le registre. Cette valeur peut provenir, si on le désire, d'une mémoire non volatile (EPROM ou EEPROM) présente sur le même substrat de circuit intégré. Cette mémoire peut contenir justement des données de correction de fréquence établies individuellement pour le circuit lors de son test électrique (après encapsulation).

On notera que dans le cas du processeur de traitement de signaux, les données de réglage de fréquence peuvent passer par les bornes d'entrée/sortie de données du processeur; ce sont des bornes extérieures qui sont obligatoirement prévues dans le circuit intégré, et il n'est donc pas nécessaire de prévoir des bornes de connexion supplémentaires pour la connexion d'éléments de réglage de fréquence (résistances ou capacités).

L'invention est particulièrement intéressante lorsque l'oscillateur concerné est justement celui qui sert à établir des signaux d'horloge pour le fonctionnement du processeur de signaux lui-même.

La réalisation pratique de l'oscillateur est de préférence la suivante : les courants de charge et décharge de la capacité sont établis par recopie des courants engendrés dans un montage de deux transistors en série avec une résistance intercalée entre ces deux transistors; pour établir un seuil de comparaison, on utilise un montage à deux transistors en série; l'un de ces transistors est monté en miroir de courant avec le transistor de charge (ou respectivement de décharge) de la capacité; l'autre transistor a sa grille connectée à la capacité et a une géométrie choisie pour conduire un courant sensiblement égal au courant du premier transistor lorsqu'il reçoit une tension sensiblement égale à la tension grille/source du transistor fournissant le courant de décharge (ou respectivement de charge) de la capacité.

La résistance mentionnée ci-dessus est de préférence parcourue par un courant engendré par la mise en parallèle de plusieurs sources de courant montées en miroir de courant les unes par rapport aux autres, ces sources étant mises en parallèle sous le contrôle du registre.

D'autres caractéristiques et avantages de l'invention apparaîtront à la lecture de la description détaillée qui suit et qui est faite en référence aux dessins annexés dans lesquels

- la figure 1 représente un schéma général d'un mode de réalisation d'un circuit intégré selon l'invention.
- la figure 2 représente un schéma détaillé d'un exemple de réalisation de l'oscillateur en technologie CMOS.

L'invention sera décrite plus particulièrement à propos de la réalisation d'un circuit intégré comportant un microprocesseur et utilisant un oscillateur OSC pour définir une fréquence d'horloge servant au séquencement des tâches exécutées par le microprocesseur.

L'oscillateur est entièrement intégré dans le même substrat semiconducteur que le microprocesseur. C'est un oscillateur à fréquence variable; la fréquence est ajustable sous la commande d'un registre R1 dont le contenu peut être chargé par le microprocesseur.

Le microprocesseur n'a été représenté que très partiellement sur la figure. Il comprend classiquement une unité centrale de traitement CPU raccordée à un bus de données (ou d'adresses et données) DB permettant l'échange de données notamment avec des mémoires (vives, mortes ou non volatiles), des ports d'entrée/sortie du circuit intégré, et des registres internes du circuit intégré.

Parmi les mémoires raccordées au bus DB, on a prévu une mémoire électriquement programmable M1, de préférence une mémoire électriquement programmable et électriquement effaçable (EEPROM). Cette mémoire peut cependant ne pas être effaçable électriquement.

La mémoire M1 peut avoir diverses utilisations dans le circuit, c'est-à-dire qu'elle n'est pas spécialement réservée au réglage de fréquence selon l'invention. Dans ce cas, on réservera une zone spécifique de la mémoire pour contenir selon l'invention des données relatives à la fréquence que doit avoir l'oscillateur.

Parmi les registres raccordés au bus DB, on a prévu un registre spécifique R1 destiné à contenir, en fonctionnement, des données liées aux données contenues dans la mémoire M1. C'est le registre R1 qui commande le réglage automatique de la fréquence de l'oscillateur. On décrira plus loin la manière dont se fait ce réglage.

En fin de fabrication du circuit intégré, il est habituel de procéder à des tests; en particulier des tests finaux sont faits après encapsulation du circuit dans un boîtier, alors que seules les broches d'accès extérieur du circuit intégré restent accessibles. Parmi ces tests, on procède à une mesure de la fréquence libre de l'oscillateur OSC; on en déduit l'écart qui existe entre la fréquence de l'oscillateur et la fréquence qu'on souhaiterait, cet écart étant dû aux fluctuations incontrôlables des paramètres des diverses étapes technologiques de fabrication (durées, températures, dosages, etc.).

On commande alors le stockage dans la mémoire M1 d'une information correspondant à cet écart. Le microprocesseur peut effectuer lui-même ce stockage.

Lors de l'utilisation du circuit, cette information est utilisée pour corriger systématiquement la fréquence de l'oscillateur afin qu'elle prenne bien la valeur désirée.

Par exemple, on peut prévoir que la mise sous tension du circuit intégré provoque une étape systématique de transfert dans le registre R1 de l'information de correction contenue dans la mémoire M1.

Tant que le microprocesseur reste alimenté en énergie, le registre R1 conserve ces données et corrige en permanence la fréquence de l'oscillateur OSC.

Dans le cas ou l'oscillateur est celui qui permet d'établir les signaux d'horloge du microprocesseur, il est préférable que l'oscillateur fonctionne au départ avec une fréquence relativement basse. Pour cela, au départ, lors de la mise sous tension, on prévoira que le registre R1 est systématiquement remis à zéro (c'est ce qu'on fait en général par des circuits de réinitialisation dans tous les microprocesseurs); et on prévoira que le contenu zéro du registre correspond à une fréquence relativement basse. Le programme de démarrage du processeur effectuera ensuite le chargement du registre pour obtenir la fréquence de fonctionnement désirée.

Avec un octet de correction, on peut corriger la fréquence par exemple par pas de 2% dans une plage de fluctuations technologiques d'environ 200% .

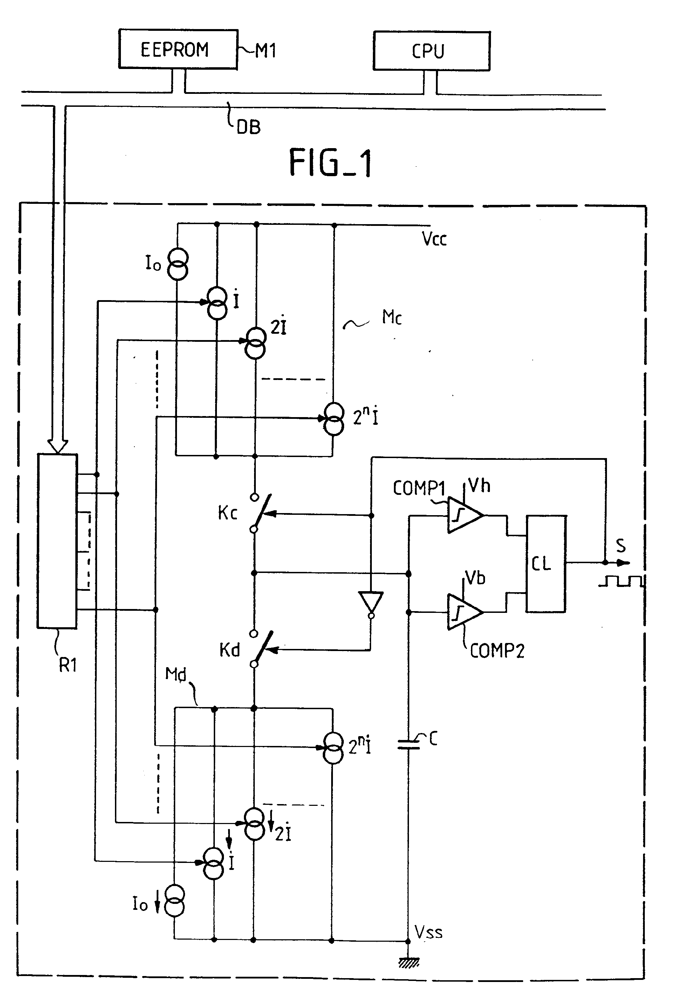

L'oscillateur OSC représenté à la figure 1 est un oscillateur à relaxation utilisant une capacité C susceptible d'être chargée par un courant de charge réglable i et déchargée par un courant de décharge qui est de préférence égal au courant de charge et qui circule en sens inverse dans la capacité.

L'ensemble de l'oscillateur est alimenté entre deux bornes d'alimentation dont l'une est à un potentiel bas Vss et l'autre à un potentiel haut Vcc.

Le courant de charge est produit par exemple par un ensemble de plusieurs sources de courant reliées entre Vcc et la capacité (cette dernière ayant par ailleurs une borne à Vss); ces sources de courant peuvent être mises en parallèle sous le contrôle du registre R1, en fonction des données contenues dans celui-ci, pour obtenir un courant de charge de valeur variable.

De même le courant de décharge est produit par un ensemble de sources de courant reliées aux bornes de la capacité. Ces sources peuvent aussi être mises parallèle sous le contrôle du registre R1, en fonction des données contenues dans celui-ci pour établir un courant de décharge de valeur variable.

La solution la plus simple est d'utiliser une pondération binaire, dans laquelle les bits stockés dans le registre R1 sont placés dans un ordre de pondération croissante, et chaque bit commande une source de courant de valeur pondérée correspondante. Ainsi, le premier bit du registre (bit de poids le plus faible) peut commander une source de courant de charge de valeur I et simultanément une source de courant de décharge de même valeur I; le deuxième bit du registre commande une source de courant de charge de valeur 2I et une source de courant de décharge de valeur 2I; et ainsi de suite, le $n^{ième}$ bit commande une source de courant de charge et une source de courant de décharge de valeur $2^nI$.

Selon le contenu du registre on obtient ainsi un courant de charge et décharge i variable entre 0 et $(2^{n+1}-1)I$, par pas égaux à I. Ce courant peut être le courant principal de charge et décharge ou être placé en parallèle avec un courant de charge ou décharge I0 de base, auquel cas, le registre sert à corriger la valeur de ce courant I0 (le courant de charge étant I0 pour un contenu zéro du registre).

Le courant de charge i constitué par la somme du courant I0 et des courants individuellement mis en service par le registre est transmis à la capacité C par l'intermédiaire d'un interrupteur Kc fermé seulement pendant la charge de la capacité.

Réciproquement, le courant de décharge i est transmis par l'intermédiaire d'un interrupteur Kd fermé seulement pendant la décharge.

Les interrupteurs Kc et Kd sont commutés en opposition de phase par des comparateurs à seuil COMP1 et COMP2 reliés à la capacité. Le comparateur à seuil COMP1 a pour fonction d'interrompre la charge de la capacité et de démarrer sa décharge lorsque la tension à ses bornes atteint un seuil haut Vh. Le comparateur COMP2 a pour fonction d'interrompre la décharge de la capacité et de recommencer la charge lorsque la tension aux bornes de la capacité atteint un seuil bas Vb. Un circuit logique CL (bascule de type RS ou analogue) recevant les sorties des comparateurs fournit les signaux de commande des interrupteurs Kc et Kd. La sortie S de ce circuit logique CL est la sortie de l'oscillateur OSC; elle fournit des créneaux à une fréquence qui est liée à la valeur (réglable par le registre R1) du courant de charge et décharge, à la valeur de la capacité C, et enfin à la valeur de l'écart entre les seuils haut et bas Vh et Vb des comparateurs COMP1 et COMP2.

Comme la technologie est en général telle que les courants I et I0 dépendent de la valeur de la tension d'alimentation Vcc, on prévoit que les comparateurs COMP1 et COMP2 sont construits à partir de sources de courant réalisées de la même manière que les sources de courant de charge et de décharge I0, I, 2I, etc.; plus exactement on prévoit que les comparateurs COMP1 et COMP2 sont construits de manière que la différence de seuils Vh-Vb soit proportionnelle au courant I d'une source de courant élémentaire; de cette manière, la durée de charge et de décharge devient indépendante de la tension Vcc : si la charge est plus lente parce que le courant élémentaire I est plus faible, l'écart de tension Vh-Vb qui définit avec le courant la durée de la charge sera proportionnellement plus faible. Au total la durée de charge et décharge, donc la fréquence de l'oscillateur, sera constante et ne dépendra pas des modifications de courant dues aux modifications de tension d'alimentation. Elle ne dépendra que du contenu du registre R1 et des paramètres de construction technologique du circuit, notamment la valeur de la capacité C.

On sait bien réaliser en technologie des circuits intégrés des sources de courant dont les valeurs sont proportionnelles entre elles avec un coefficient de proportionalité KO précisément connu, même si on ne connaît pas la valeur absolue de ces courants ni leur dépendance vis-à-vis de la tension d'alimentation.

Si le registre R1 sert essentiellement à recevoir une correction de fréquence liée aux fluctuations technologiques, c'est par ce registre qu'on prendra en compte la valeur de la capacité C (sujette aux fluctuations technologiques).

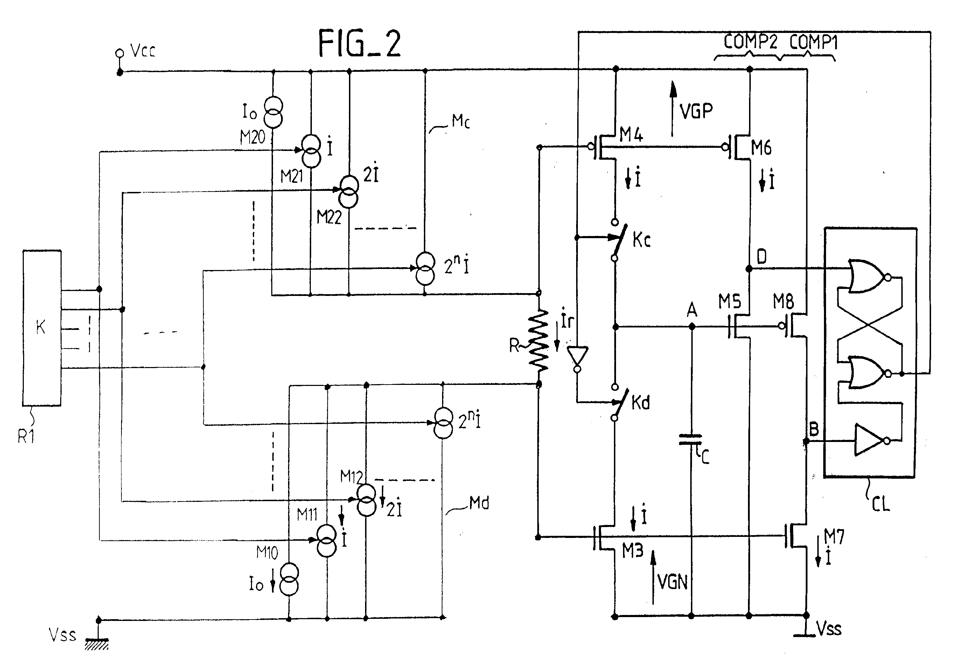

La figure 2 représente un exemple de réalisation détaillée de l'oscillateur selon l'invention.

Par commodité de construction, le courant de charge de la capacité C n'est pas obtenu directement dans cette réalisation par la mise en parallèle de plusieurs sources de courant commandées par le registre R1. Il est obtenu à partir d'un miroir de courant recopiant un courant de référence. Il reste cependant, d'une manière plus indirecte, lié au contenu du registre R1.

Ce courant de référence n'est pas fixe; il varie en fonction du contenu du registre et il sert par ailleurs à définir des tensions grille/source de transistors qui établiront les seuils de comparaison dans les comparateurs COMP1 et COMP2.

Le courant de référence, désigné par Ir, est établi dans une résistance R de la manière suivante : un ensemble de décharge Md de sources de courant élémentaires pondérées commandées par le registre R1 est connecté en parallèle entre la borne d'alimentation basse Vss et une première extrémité de la résistance R. Ces sources de courant commandées par le registre sont montées en miroirs de courant avec une proportionnalité du courant parfaitement définies les unes par rapport aux autres selon une pondération qui correspond à la pondération des bits du registre R1. La source de courant M10 définit un courant de base I0; M11 correspond à une source de courant élémentaire de valeur I; M12 correspond à une source de courant élémentaire de courant double 2I, etc. Ces sources de courant sont mises en service ou déconnectées sous la commande des bits du registre R1.

Symétriquement, un autre ensemble de charge Mc de sources de courant M20, M21, M22, etc, sont connectées en parallèle (en fonction de l'état des bits du registre) entre l'autre borne d'alimentation Vcc et la deuxième extrémité de la résistance R. Les sources de courant M20, M21, M22, etc, sont également toutes montées en miroirs de courant les unes par rapport aux autres et ont des proportionnalités de courant parfaitement définies les unes par rapport aux autres selon la même pondération que les bits respectifs du registre qui permettent de les mettre en service ou hors service.

Lorsque le circuit fonctionne, il s'établit dans la résistance R un courant Ir qui est la somme des courants de toutes ces sources de courant.

Si I est le courant élémentaire de plus faible poids parcourant les sources de courant M11 et M21 qui sont commandées par le ,bit de poids le plus faible du registre R1, on peut écrire que le courant Ir est :

$$Ir = (K + K0)I,$$

où K (nombre binaire) représente le contenu du registre et K0 (pas forcément entier) représente le rapport entre le courant de base I0 et le courant élémentaire de plus faible poids I.

Il s'établit alors une différence de potentiel RIr dans la résistance R.

Il en résulte par soustraction qu'il s'établit entre la borne Vss et la sortie de courant de l'ensemble de décharge Md, une différence de potentiel VGN, et qu'il s'établit entre la borne Vcc et la sortie de l'ensemble de charge Mc, une différence de potentiel VGP, telles que :

$$Vcc-Vss-(VGP + VGN) = RIr = R(K + K0)I$$

Il s'établit ainsi un équilibre liant les tensions VGN et VGP au courant de référence Ir. Les tensions VGN et VGP dépendent, sans qu'on en ait un contrôle précis, des caractéristiques des sources de courant, de la valeur de la résistance R, et de la valeur de la tension d'alimentation Vcc-Vss, mais elles sont aussi liées directement et de manière connue au contenu du registre. Ces tensions VGN et VGP vont servir de référence de tension pour les comparateurs.

Le principe de construction de l'oscillateur selon l'invention consiste alors, comme on va le voir, à établir d'une part des courants de charge et décharge de la capacité C qui sont proportionnels au courant I (par utilisation de miroirs de courant), et à établir d'autre part une différence de seuils de comparateurs qui soit justement égale à Vcc-Vss-VGP-VGN (également grâce à des miroirs de courant), et qui soit donc par contrecoup aussi proportionnelle, mais avec un coefficient de proportionalité K dépendant du contenu du registre R1 (donc connu et réglable), au courant I.

Le principe utilisé dans la réalisation de la figure 2 pour rendre Vh-Vb proportionnel au courant de charge et décharge nécessite que le courant de charge et décharge ne soit pas directement commandé par le registre R1, mais seulement par l'intermédiaire de miroirs de courant; mais cela permet de réaliser les comparateurs COMP1 et COMP2 d'une manière très simple, avec seulement deux transistors chacun.

Le courant de charge de la capacité C, établi pendant les périodes de charge par l'interrupteur Kc, est fourni par un transistor M4 à canal P monté en miroir de courant par rapport aux sources de courant M20, M21, M22, etc. avec sa grille connectée à la sortie de l'ensemble de charge Mc ; il fournit un courant proportionnel à I, par exemple égal à I pour simplifier.

De même, le courant de décharge dans la capacité C, établi pendant les périodes de décharge par l'interrupteur Kd, est fourni par un transistor à canal N M3 monté en miroir de courant par rapport aux sources de courant M10, M11, M12, etc. avec sa grille connectée à la sortie de l'ensemble de décharge Md ; il fournit donc également un courant de décharge proportionnel à I, de préférence égal à I.

Comme on le voit sur la figure 2, pendant la charge le transistor M4 est monté entre une borne A de la capacité C et la borne Vcc. L'autre borne de la capacité est à la masse (Vss). Le transistor M3 est déconnecté. Pendant la décharge, le transistor M4 est déconnecté de la borne A, le transistor M3 est connecté entre la borne A et Vss.

On a donc établi dans la capacité des courants de charge et décharge qui ne dépendent que du courant de base I des sources élémentaires, la précision sur les rapports de géométrie des différents transistors d'un circuit intégré pouvant être considérée comme très bonne dans l'application décrite ici.

Il reste à établir des seuils de comparateur Vh et Vb tels que Vh-Vb soit égal à Vcc-Vss-VGP-VGN et soit par conséquent aussi proportionnel à I.

Le premier comparateur, COMP1, définissant le seuil haut Vh, est constitué par un ensemble de deux transistors M7 et M8 connectés en série entre Vss et Vcc. M7 est un transistor à canal N monté en miroir de courant par rapport au transistor M3 déjà mentionné. Par l'expression "montage en miroir de courant", on entend le montage très classique de transistors ayant leurs sources réunies et leurs grilles réunies, et conduisant des courants proportionnels à leur géométrie, c'est-à-dire à leur rapport largeur sur longueur de canal. Le transistor M7 tend donc à être parcouru par un courant proportionnel à I, de préférence égal à I selon sa géométrie. Le transistor M8 est à canal P; sa grille est commandée par la borne A de la capacité et il peut donc être rendu conducteur ou bloqué en fonction de la tension de charge de la capacité. Si le transistor M7 a une géométrie choisie pour conduire un courant I, alors le transistor M8 a une géométrie choisie pour qu'il conduise sensiblement un courant I lorsqu'il a sensiblement une tension grille/source égale à VGP.

Le deuxième comparateur, COMP2, définissant le seuil bas Vb, est constitué aussi par un ensemble de deux transistors M5 et M6 connectés en série entre Vss et Vcc. M5 est un transistor à canal N dont la grille est commandée par la borne A de la capacité. M6 est un transistor à canal P monté en miroir de courant avec le transistor M4 et tendant donc à établir dans la branche M5, M6 un courant proportionnel à I, de préférence égal à I selon sa géométrie. Si M6 a une géométrie pour conduire un courant I, alors on donne à M5 une géométrie pour conduire sensiblement un courant I, lorsqu'il a sensiblement une tension grille/source égale à VGN.

Les comparateurs fonctionnent de la manière suivante : pendant la charge de la capacité (interrupteur Kc fermé, Kd ouvert), le transistor M7 tend à conduire un courant I par effet de miroir de courant; mais le transistor M8 tend à conduire un courant plus grand que I car sa tension grille/source est initialement inférieure à VGP (M8 est un transistor à canal P dont la géométrie est telle qu'il conduise un courant I lorsque sa tension grille-source est VGP). Cela crée un déséquilibre tendant à tirer vers Vcc le potentiel du noeud B entre les transistors M7 et M8. De même, pendant la charge de la capacité, le transistor M6 tend à conduire un courant I alors que le transistor M5 tend à conduire un courant plus grand que I puisque sa tension grille/source est initialement supérieure à VGN (M5 est un transistor à canal N dont la géométrie est telle qu'il conduise un courant I lorsque sa tension grille/source est VGN). Cela crée un déséquilibre tendant à tirer le potentiel du noeud D (entre les transistors M5 et M6) vers Vss.

Le circuit logique de décision CL est ici une bascule de type RS, dont les entrées sont reliées aux noeuds B et D; on peut considérer que l'entrée D est une entrée de basculement et l'entrée B une entrée de rétablissement : la bascule ne change d'état pour fermer l'interrupteur Kc et ouvrir l'interrupteur Kd que lorsque son entrée D passe de l'état logique bas à l'état logique haut, la bascule ne changeant ensuite d'état pour fermer l'interrupteur Kd et ouvrir l'interrupteur Kc que sous l'effet du passage à l'état logique bas de l'autre entrée B. Les autres sens de changement d'état des noeuds B et D n'ont pas d'influence sur la bascule.

Ainsi, pendant la charge de la capacité, l'état fermé de l'interrupteur de charge Kc est confirmé par l'état logique haut du noeud B.

Lorsque le potentiel du noeud A atteint la valeur Vcc-VGP, le transistor M8 se trouve polarisé pour conduire un courant I. Le noeud B descend vers Vss et change d'état logique. Cela provoque le basculement du circuit logique de décision CL, qui inverse alors l'état des interrupteurs Kc et Kd. Vcc-VGP représente le seuil haut Vh du comparateur COMP1.

La décharge de la capacité commence. Tout d'abord, le courant du transistor M8 se remet à augmenter au dessus de I, ce qui tend à remettre au niveau logique haut le noeud B, mais cela n'affecte pas l'état de la bascule qui ne peut maintenant changer d'état que sous l'action du noeud D. Ensuite, le transistor M6 tend à conduire un courant I et le transistor M5 un courant plus grand que I, de sorte que le noeud D est tiré vers Vss. Lorsque le potentiel du noeud A descend à la valeur Vss+VGN, le potentiel grille/source du transistor M5 devient juste ce qu'il faut pour conduire un courant I comme le transistor M6. L'état logique du noeud D tend à changer vers l'état logique haut. La bascule du circuit CL change à nouveau d'état pour recommencer un cycle de charge. Le seuil de basculement bas Vb du comparateur COMP2 est donc Vss+VGN.

La différence Vh-Vb entre les seuils haut et bas est donc égale à Vcc-Vss-VGP-VGN.

C'est justement ce que l'on souhaitait.

Il en résulte donc que le courant de charge et décharge de la capacité, C, égal à I donc à Ir/(K+K0), donc à (Vcc-Vss-VGP-VGN)/R(K+K0) comme expliqué plus haut est bien proportionnel à (Vcc-Vss-VGP-VGN) donc à Vh-Vb.

La période de l'oscillateur, en supposant que les charges et décharges sont parfaitement linéaires est :
T = 2C(Vh-Vb)/I Elle est donc égale à :
T = 2C(Vcc-Vss-VGP-VGN)/I,
et, comme I = (Vcc-Vss-VGP-VGN)/R(K+KO), la période est
T = 2CR(K+KO)

Elle est indépendante de la tension d'alimentation. Elle ne dépend que de R et C et du contenu du registre. R et C dépendent de la technologie et de ses fluctuations, K0 est connu avec précision; K est le contenu du registre R1 qui est choisi à volonté et qui peut justement servir à ajuster la fréquence en fonction des fluctuations technologiques non maîtrisées de R et C.

On a ainsi décrit un moyen pour réaliser sans problème un oscillateur purement interne dans un circuit intégré, sans les inconvénients qui en résultaient dans la technique antérieure, et en particulier avec une fréquence indépendante de la tension d'alimentation.

## Revendications

1. Circuit-intégré comprenant un un oscillateur à relaxation (OSC) comportant une capacité (C) et des moyens de charge (Mc) et décharge (Md) de la capacité avec des sources de courants élémentaires (IO, I, 2I) qui sont mises en parallèle sélectivement, un un comparateur à seuils (COMP1, COMP2) pour déclencher la charge de la capacité lorsque la tension aux bornes de celle-ci descend au dessous d'un seuil bas Vb, et pour déclencher la décharge de la capacité lorsque la tension aux bornes de celle-ci monte au dessus d'un seuil haut Vh, ce comparateur établissant des seuils haut et bas Vh et Vb tels que Vh-Vb soit proportionnel au courant de charge et décharge de la capacité cet oscillateur comportant en outre un registre (R1) contenant des données de réglage de fréquence de l'oscillateur, ce registre commandant la mise en parallèle sélective de sources de courant élémentaires en fonction de son contenu, les courants de charge et décharge de la capacité étant liés aux courants des sources élémentaires ainsi mises en parallèle.

2. Circuit intégré selon la revendication 1, caractérisé en ce qu'il comporte un processeur de signaux apte à charger le contenu du registre.

3. Circuit intégré selon la revendication 2, caractérisé en ce que le contenu du registre est chargé à partir d'une mémoire (M1) non volatile formée sur le même substrat de circuit intégré et contenant des données individuelles de correction de fréquence pour le circuit intégré.

4. Circuit intégré selon l'une des revendications 2 et 3, caractérisé en ce que l'oscillateur sert à établir des signaux d'horloge pour le processeur.

5. Circuit intégré selon l'une des revendications 1 à 4, caractérisé en ce que les sources de courant élémentaires ont des valeurs pondérées, par exemple selon un code binaire pur, cette pondération correspondant à une pondération identique des bits du registre.

6. Circuit intégré selon l'une des revendications 1 à 5, caractérisé en ce qu'il comporte un premier transistor (M4) à canal P pour la charge de la capacité, un deuxième transistor (M3) à canal N pour la décharge de la capacité, un troisième transistor (M6) à canal P monté en miroir de courant par rapport au premier transistor, en série avec un quatrième transistor (M5) à canal N dont la grille est reliée à la capacité et dont la géométrie est choisie pour qu'il conduise le même courant que le troisième transistor (M6) lorsque sa tension grille-source est égale à la tension grille-source du deuxième transistor (M3).

7. Circuit intégré selon la revendication 6, caractérisé en ce qu'il comporte en outre un cinquième transistor (M8) à canal P en série avec un sixième transistor (M7) à canal N, le sixième transistor étant monté en miroir de courant avec le deuxième transistor (M3), le cinquième transistor ayant sa grille reliée à la capacité et ayant une géométrie choisie pour qu'il conduise le même courant que le sixième lorsque sa tension grille-source est égale à la tension grille/source du premier transistor.

8. Circuit-intégré selon l'une des revendications 1 à 7, caractérisé en ce que le registre (R1) commande la mise en conduction sélective de sources de courant en parallèle (M11,M12 ; M21,M22) et montées en miroirs de courant les unes par rapport aux autres, la somme des courants générés par ces sources de courant étant appliquée à une résistance (R), et en ce qu'il est prévu des transistors (M3, M4) de géométrie bien définie et montés en miroir de courant par rapport aux sources de courant, pour assurer la charge et la décharge de la capacité.

## Patentansprüche

1. Integrierte Schaltung mit einem Kipposzillator (OSC) umfassend eine Kapazität (C) sowie eine Ladeeinrichtung (Mc) und eine Entladeeinrichtung (Md) für die Kapazität mit Elementarstromquellen (I0, I, 2I), die selektiv parallel geschaltet sind, einen Schwellenwert-Komparator (COMP1, COMP2) für die Einleitung des Ladens der Kapazität, wenn die Spannung an seinen Anschlüssen unter einen unteren Schwellenwert Vb absinkt und für das Einleiten des Entladens der Kapazität, wenn die Spannung an seinen Anschlüssen über einen oberen Schwellenwert Vh ansteigt, wobei der Komparator den oberen und den unteren Schwellwert Vh und Vb derart einstellt, daß Vh - Vb proportional dem Ladestrom und Entladestrom der Kapazität ist und wobei der Generator außerdem ein Register (R1) aufweist, das die Daten für die Regelung der Frequenz des Oszillators enthält, wobei das Register das selektive Parallelschalten der Elementar-Stromquellen in Abhängigkeit von seinem Inhalt regelt und wobei die Lade- und Entladeströme der Kapazität mit den so parallel geschalteten Elementar-Stromquellen gekoppelt sind.

2. Integrierte Schaltung nach Anspruch 1, dadurch gekennzeichnet, daß sie einen Signalprozessor aufweist, der geeignet ist, den Inhalt des Registers zu laden.

3. Integrierte Schaltung nach Anspruch 2, dadurch gekennzeichnet, daß der Inhalt des Registers geladen ist ausgehend von einem nichtflüchtigen Speicher (M1), der auf dem Substrat der integrierten Schaltung gebildet ist und die individuellen Korrekturdaten der Frequenz für die integrierte Schaltung enthält.

4. Integrierte Schaltung nach Anspruch 2 oder 3, dadurch gekennzeichnet, daß der Oszillator zum Erzeugen der Taktimpulssignale für den Prozessor dient.

5. Integrierte Schaltung nach einem der Ansprüche 1 bis 4, dadurch gekennzeichnet, daß die Elementar-Stromquellen bewertete Werte aufweisen, beispielsweise gemäß einem reinen Binärcode, wobei diese Bewertung einer identischen Bewertung der Bits des Registers entspricht.

6. Integrierte Schaltung nach einem der Ansprüche 1 bis 5, dadurch gekennzeichnet, daß sie einen ersten p-Kanal-Transistor (M4) für das Laden der Kapazität, einen zweiten n-Kanal-Transistor (M3) für das Entladen der Kapazität, einen dritten p-Kanal-Transistor, der in bezug auf den ersten Transistor in Stromspiegelschaltung (Source und Gate sind jeweils miteinander verbunden) und mit einem vierten n-Kanal-Transistor (M5) in Reihe geschaltet ist, dessen Gate mit der Kapazität verbunden ist und dessen Geometrie so gewählt ist, daß durch ihn der gleiche Strom wie durch den dritten Transistor (M6) fließt, wenn seine Gate-Source-Spannung gleich ist der Gate-Source-Spannung des zweiten Transistors (M3).

7. Integrierte Schaltung nach Anspruch 6, dadurch gekennzeichnet, daß sie weiterhin einen fünften p-Kanal-Transistor (M8) aufweist, der in Reihe mit einem sechsten n-Kanal-Transistor (M7) geschaltet ist, daß der sechste Transistor mit dem zweiten Transistor (M3) in Stromspiegelschaltung geschaltet ist, daß das Gate des fünften Transistors mit der Kapazität verbunden ist und eine Geometrie aufweist, die so gewählt ist, daß durch ihn der gleiche Strom fließt wie durch den sechsten Transistor, wenn seine Gate-Source-Spannung gleich ist der Gate-Source-Spannung des ersten Transistors.

8. Integrierte Schaltung nach einem der Ansprüche 1 bis 7, dadurch gekennzeichnet, daß das Register (R1) die selektive Einschaltung der Stromquellen in Parallelschaltung (M11, M12; M21, M22) steuert, die in Stromspiegelschaltung in bezug aufeinander geschaltet sind, wobei die durch die Stromquellen erzeugte Summe der Ströme zu einem Widerstand (R) geführt wird, und daß Transistoren (M3, M4) mit einer genau definierten Geometrie vorgesehen sind, die in Stromspiegelschaltung in bezug auf die Stromquellen geschaltet sind, um das Laden und Entladen der Kapazität zu sichern.

## Claims

1. An integrated circuit comprising a relaxation oscillator (OSC) comprising a capacitance (C) and means for charging (Mc) and discharging (Md) the capacitance with primary current sources (I0, I, 2I) which are selectively put in parallel, a threshold comparator (COMP1, COMP2) for triggering the charging of the capacitance when the voltage at the terminals of the latter decreases below a low threshold value Vb, and for triggering the discharging of the capacitance when the voltage at the terminals of the latter rises above a high threshold value Vh, this comparator establishing high and low thresholds Vh and Vb such that Vh-Vb is proportional to the charging current and the discharging current of the capacitance, and also comprising a register (R1) containing data for controlling the frequency of the oscillator, this register controlling the selective placing in parallel of primary current sources depending on its content the currents for charging and discharging the capacitance being related to the currents of the primary sources thus put in parallel.

2. An integrated circuit as claimed in claim 1, characterized in that it comprises a signal processor adapted to load the contents of the register.

3. An integrated circuit as claimed in claim 2, characterized in that the contents of the register are loaded from a non-volatile memory (M1) formed on the same substrate as the integrated circuit and containing individual data for frequency correction for the integrated circuit.

4. An integrated circuit as claimed in any one of claims 2 and 3, characterized in that the oscillator serves to establish clock signals for the processor.

5. An integrated circuit as claimed in any one of claims 1 to 4, characterized in that the primary current sources have weighted values, for example in accordance with a purely binary code, this weighting corresponding to an identical weighting of bits in the register.

6. An integrated circuit as claimed in any one of claims 1 to 5, characterized in that it comprises a first, P channel transistor (M4) for charging the capacitance, a second, N channel transistor (M3) for discharging the capacitance, a third, P channel transistor (M6) mounted in current mirror relationship with respect to the first transistor, in series with a fourth, N channel transistor (M5) the gate of which is connected to the capacitance and the geometry of which is chosen so th at it conducts the same current as the th ird transistor (M6) when its gate-source potential difference is equal to the gate-source potential difference of the second transistor (M3).

7. An integrated circuit as claimed in claim 6, characterized in that it also comprises a fifth, P channel transistor (M8) mounted in series with a sixth, N channel transistor (M7), the sixth transistor being mounted in current mirror relationship with respect to the second transistor (M3), the fifth transistor having its gate connected to the capacitance and having a geometry chosen so that it conducts the same current as the sixth transistor when its gate-source potential difference is equal to the gate-source potential difference of the first transistor.

8. An integrated circuit as claimed in any one of claims 1 to 7, characterized in that the register (R1) controls the selective binging into conduction of current sources (M11, M12; M21, M22) mounted in parallel and in current mirror relationship to one another, the sum of the currents generated by these sources of current being applied to a resistor (R), and in that it is provided with transistors (M3, M4), which have a well defined geometry and are mounted in current mirror relationship with respect to the current sources, to provide the charging and the discharging of the capacitance.

FIG_1

FIG_2

EP 0 407 269 B1